# EUROPÄISCHE PATENTANMELDUNG

(11) **EP 3 435 503 A1**
(43) Veröffentlichungstag der Anmeldung: **30.01.2019**
(21) Anmeldenummer: 17183436.9
(22) Anmeldetag: 27.07.2017
(51) Int. Cl.: H02H 3/16, G01R 31/02, H02M 5/40, H02J 3/00

(54) **ORTEN EINES ERDSCHLUSSES IN EINEM IT-NETZ**

(71) Anmelder: Siemens Aktiengesellschaft, 80333 München (DE)
(72) Erfinder: Weis, Benno, 91334 Hemhofen (DE)

(57) **Zusammenfassung**

Die Erfindung betrifft ein Verfahren zum Orten eines Erdschlusses in einem IT-Netz (1), das ein Stromübertragungsnetz (5), eine rotierende elektrische Maschine (7, 8) und einen Stromrichter (9, 10) aufweist, wobei der Stromrichter (9, 10) einen mit der elektrischen Maschine (7, 8) verbundenen Wechselrichter (17) aufweist. Bei dem Verfahren wird eine Gleichtaktspannungseigenschaft einer Gleichtaktspannung des Stromrichters (9, 10) oder des Stromübertragungsnetzes (5) erfasst und die Gleichtaktspannungseigenschaft wird mit einer Ausgangsspannungseigenschaft einer Ausgangsspannung des Wechselrichters (17) verglichen. Im Falle eines Erdschlusses in dem IT-Netz (1) wird anhand des Vergleiches der Gleichtaktspannungseigenschaft mit der Ausgangsspannungseigenschaft darauf geschlossen, ob ein dem Stromrichter (9, 10) nachgeschalteter Maschinenbereich (21, 22) des IT-Netzes (1), der die elektrische Maschine (7, 8) und eine Verbindungsleitung (19, 20) zwischen der elektrischen Maschine (7, 8) und dem Stromrichter (9, 10) aufweist, die Ursache des Erdschlusses ist.

## Beschreibung

Die Erfindung betrifft ein Verfahren zum Orten eines Erdschlusses in einem IT-Netz, das ein Stromübertragungsnetz, eine rotierende elektrische Maschine und einen Stromrichter, der eingangsseitig an das Stromübertragungsnetz und ausgangsseitig an die rotierende elektrische Maschine angeschlossen ist, aufweist.

In IT-Netzen zur elektrischen Stromversorgung ist es grundsätzlich zulässig, das IT-Netz im Falle eines einfachen Erdschlusses weiter zu betreiben. In IT-Netzen, die rotierende elektrische Maschinen aufweisen, die jeweils über einen Stromrichter an ein Stromübertragungsnetz des IT-Netzes angeschlossen sind, gilt dies auch für den Fall, dass der Erdschluss in dem Stromübertragungsnetz auftritt. In diesem Fall erhöht sich lediglich die grundfrequente Gleichtaktspannung aller angeschlossenen Verbraucher.

Tritt der Erdschluss jedoch in einem Maschinenbereich des IT-Netzes auf, der eine rotierende elektrische Maschine und eine Verbindungsleitung zwischen der elektrischen Maschine und dem zugehörigen Stromrichter aufweist, so werden das gesamte IT-Netz und damit auch alle angeschlossenen Verbraucher mit der pulsfrequenten Ausgangsspannung dieses Stromrichters beaufschlagt. Dies kann dazu führen, dass Verbraucher an dem IT-Netz überlastet werden. Zudem ist es möglich, dass die elektromagnetische Abstrahlung des IT-Netzes unzulässig hoch wird und benachbarte elektrische Geräte stört. Diese Problematik existiert sowohl in Wechselstrom-IT-Netzen als auch in Gleichstrom-IT-Netzen.

Üblicherweise wird ein Erdschluss, der in einem Maschinenbereich eines IT-Netzes auftritt, durch einen Isolationswächter erkannt, der detektiert, ob ein unzulässiger Gleichtaktstrom fließt. Alternativ kann der Erdschluss auch dadurch erkannt werden, dass eine Netzspannung des IT-Netzes gegenüber einem Erdpotential überwacht wird, und auf einen Erdschluss in einem Maschinenbereich eines IT-Netzes wird geschlossen, wenn die Netzspannung pulsfrequente Anteile enthält. Mit keinem dieser Verfahren kann jedoch festgestellt werden, in welchem Maschinenbereich des IT-Netzes der Erdschluss auftritt. Deshalb werden in der Regel alle Verbraucher an dem IT-Netz abgeschaltet, wenn erkannt wird, dass ein Erdschluss in einem Maschinenbereich auftritt.

Der Erfindung liegt die Aufgabe zugrunde, ein verbessertes Verfahren zum Orten eines Erdschlusses in einem IT-Netz anzugeben, das insbesondere die Identifizierung desjenigen Maschinenbereichs, in dem ein Erdschluss auftritt, ermöglicht.

Die Aufgabe wird erfindungsgemäß durch die Merkmale des Anspruchs 1 gelöst.

Vorteilhafte Ausgestaltungen der Erfindung sind Gegenstand der Unteransprüche.

Das erfindungsgemäße Verfahren dient dem Orten eines Erdschlusses in einem IT-Netz, das ein Stromübertragungsnetz, eine rotierende elektrische Maschine und einen Stromrichter aufweist, wobei der Stromrichter eingangsseitig an das Stromübertragungsnetz und ausgangsseitig an die rotierende elektrische Maschine angeschlossen ist und einen Gleichspannungszwischenkreis und einen mit dem Gleichspannungszwischenkreis und der elektrischen Maschine verbundenen Wechselrichter aufweist. Bei dem Verfahren wird eine Gleichtaktspannungseigenschaft einer Gleichtaktspannung des Stromrichters oder des Stromübertragungsnetzes erfasst, die Gleichtaktspannungseigenschaft wird mit einer Ausgangsspannungseigenschaft einer Ausgangsspannung des Wechselrichters verglichen, und im Falle eines Erdschlusses in dem IT-Netz wird anhand des Vergleiches der Gleichtaktspannungseigenschaft mit der Ausgangsspannungseigenschaft darauf geschlossen, ob ein dem Stromrichter nachgeschalteter Maschinenbereich des IT-Netzes, der die elektrische Maschine und eine Verbindungsleitung zwischen der elektrischen Maschine und dem Stromrichter aufweist, die Ursache des Erdschlusses ist.

Unter einem Wechselrichter wird hier und im Folgenden stets ein Wechselrichter verstanden, der pulsweitenmoduliert angesteuerte elektronische Schalteinheiten aufweist.

Die Erfindung nutzt aus, dass im Falle eines Erdschlusses in einem Maschinenbereich des IT-Netzes die Ausgangsspannung des mit dem Maschinenbereich verbundenen Wechselrichters die Gleichtaktspannungen des den Wechselrichter aufweisenden Stromrichters und des Stromübertragungsnetzes beeinflusst. Daher kann durch den Vergleich einer Ausgangsspannungseigenschaft einer Ausgangsspannung des Wechselrichters mit einer dazu korrespondierenden Gleichtaktspannungseigenschaft einer Gleichtaktspannung des Stromrichters oder des Stromübertragungsnetzes ermittelt werden, ob in dem mit diesem Wechselrichter verbundenen Maschinenbereich ein Erdschluss auftritt.

Indem alle Stromrichter des IT-Netzes, die jeweils mit einem Maschinenbereich verbunden sind, auf diese Weise überwacht werden, kann festgestellt werden, in welchem dieser Maschinenbereiche ein Erdschluss auftritt. Dies ermöglicht insbesondere, gezielt denjenigen Maschinenbereich abzuschalten, in dem ein Erdschluss auftritt, so dass das IT-Netz im Falle eines Erdschlusses in einem Maschinenbereich weiter betrieben werden kann. Das erfindungsgemäße Verfahren ist daher besonders vorteilhaft in IT-Netzen, die mehrere rotierende elektrische Maschinen aufweisen, die jeweils gemäß Anspruch 1 über einen Stromrichter mit dem Stromübertragungsnetz des IT-Netzes verbunden sind. Die Formulierung des Anspruchs 1, dass das IT-Netz eine rotierende elektrische Maschine und einen mit ihr verbundenen Stromrichter aufweist, ist daher nicht in dem Sinne zu verstehen, dass das IT-Netz nur eine rotierende elektrische Maschine und einen mit ihr verbundenen Stromrichter aufweist, sondern dass das IT-Netz wenigstens eine rotierende elektrische Maschine aufweist, die gemäß Anspruch 1 über einen Stromrichter mit dem Stromübertragungsnetz des IT-Netzes verbunden ist.

Das erfindungsgemäße Verfahren kann insbesondere mit einem geringen Aufwand und daher kostengünstig realisiert werden, da zu seiner Ausführung kein Bauteil oder Gerät erforderlich ist, das in dem Leistungspfad einer rotierenden elektrischen Maschine liegt.

Ausgestaltungen der Erfindung sehen vor, dass als Gleichtaktspannungseigenschaft Spannungsimpulse entweder einer Spannung zwischen einem Zwischenkreispotential des Gleichspannungszwischenkreises des Stromrichters und einem Erdpotential oder einer Netzspannung des Stromübertragungsnetzes gegenüber dem Erdpotential erfasst werden, als Ausgangsspannungseigenschaft Schalthandlungen einer Phase des Wechselrichters verwendet werden und auf den Maschinenbereich als Ursache des Erdschlusses geschlossen wird, wenn die Spannungsimpulse zeitgleich mit den Schalthandlungen erfolgen.

Diese Ausgestaltungen der Erfindung nutzen aus, dass im Falle eines Erdschlusses in einem Maschinenbereich des IT-Netzes die Spannung an dem Gleichspannungszwischenkreis des mit diesem Maschinenbereich verbundenen Stromrichters und die Netzspannung des Stromübertragungsnetzes des IT-Netzes (jeweils gegenüber dem Erdpotential) mit der pulsfrequenten Ausgangsspannung des Wechselrichters dieses Stromrichters beaufschlagt werden. Daher kann ein Erdschluss in einem Maschinenbereich des IT-Netzes durch eine zeitliche Übereinstimmung von Spannungsimpulsen der Spannung an dem Gleichspannungszwischenkreis oder der Netzspannung mit den Schalthandlungen einer Phase des mit dem Maschinenbereich verbundenen Wechselrichters erkannt werden.

Eine Weitergestaltung der vorgenannten Ausgestaltungen der Erfindung sieht vor, dass eine Schwellenzeitdauer vorgegeben wird und ein Spannungsimpuls als zeitgleich mit einer Schalthandlung definiert wird, wenn ein zeitlicher Abstand zwischen dem Spannungsimpuls und der Schalthandlung kleiner als die Schwellenzeitdauer ist. Beispielsweise wird eine Schwellenzeitdauer vorgegeben, die kleiner als 10 µs ist.

Diese Weitergestaltung der Erfindung berücksichtigt, dass die Spannungsimpulse zeitlich etwas verzögert auf die Schalthandlungen folgen. Ferner können durch die Schwellenzeitdauer Messfehler bei der Bestimmung der zeitlichen Korrelation der Spannungsimpulse und Schalthandlungen kompensiert werden.

Eine weitere Weitergestaltung der vorgenannten Ausgestaltungen der Erfindung sieht vor, dass eine Zähldauer, beispielsweise etwa eine Sekunde, und ein Anzahlschwellenwert, beispielsweise etwa 1000, vorgegeben werden und innerhalb der Zähldauer eine Bewertungsanzahl von zeitgleichen Spannungsimpulsen und Schalthandlungen erfasst wird, und dass auf den Maschinenbereich als Ursache des Erdschlusses geschlossen wird, wenn die Bewertungsanzahl den Anzahlschwellenwert überschreitet.

Diese Weitergestaltung der Erfindung berücksichtigt, dass die Schalthandlungen pulsförmig sind und daher von den Schalthandlungen verursachte Spannungsimpulse ebenfalls pulsförmig sind. Ein Erdschluss in einem Maschinenbereich verursacht daher eine Vielzahl von in kurzen zeitlichen Abständen aufeinander folgenden Spannungsimpulsen, die zeitlich zu den Schalthandlungen des mit dem Maschinenbereich verbundenen Wechselrichters korreliert sind. Auf den Maschinenbereich als Ursache des Erdschlusses kann daher besonders zuverlässig geschlossen wird, wenn die Pulsmuster der Spannungsimpulse und der Schalthandlungen weitgehend übereinstimmen. Eine derartige Übereinstimmung wird durch den Anzahlschwellenwert für innerhalb der Zähldauer gleichzeitig erfolgende Spannungsimpulse und Schalthandlungen quantifiziert.

Weitere Weitergestaltungen der vorgenannten Ausgestaltungen der Erfindung sehen vor, dass die Schalthandlungen einer Phase des Wechselrichters entweder durch eine Messung der Ausgangsspannung der Phase gegen ein Zwischenkreispotential des Gleichspannungszwischenkreises erfasst oder aus Ansteuersignalen zur Ansteuerung der Phase ermittelt werden.

Bei diesen Weitergestaltungen der Erfindung werden die Schalthandlungen einer Phase des Wechselrichters also entweder aus einer Messung der Ausgangsspannung der Phase oder aus Ansteuersignalen zur Ansteuerung der Phase ermittelt. Die Erfassung der Schalthandlungen durch eine Messung der Ausgangsspannung ermöglicht eine zuverlässige Bestimmung der tatsächlich erfolgenden Schalthandlungen. Die Ermittlung der Schalthandlungen aus den Ansteuersignalen hat demgegenüber den Vorteil, dass die Ausgangsspannung der Phase nicht gemessen werden muss.

Eine weitere Ausgestaltung der Erfindung sieht vor, dass als Gleichtaktspannungseigenschaft ein Frequenzspektrum einer Netzspannung des Stromübertragungsnetzes gegenüber einem Erdpotential erfasst wird, als Ausgangsspannungseigenschaft eine Ausgangsgrundfrequenz der Ausgangsspannung des Wechselrichters verwendet wird und auf den Maschinenbereich als Ursache des Erdschlusses geschlossen wird, wenn das Frequenzspektrum der Netzspannung einen mit der Ausgangsgrundfrequenz übereinstimmenden Spektralanteil aufweist. Im Falle eines mehrphasigen Stromübertragungsnetzes wird als Netzspannung beispielsweise eine Phasenspannung oder die Summe aller Phasenspannungen des Stromübertragungsnetzes gegenüber einem Erdpotential verwendet.

Diese Ausgestaltung der Erfindung nutzt aus, dass im Falle eines Erdschlusses in einem Maschinenbereich des IT-Netzes die Ausgangsgrundfrequenz der Ausgangsspannung des Wechselrichters in das Stromübertragungsnetz des IT-Netzes übertragen wird, so dass die Phasenspannungen des Stromübertragungsnetzes gegen ein Erdpotential nicht nur einen Spektralanteil bei ihrer Betriebsfrequenz (z.B. 50 Hz oder 60 Hz) enthalten, sondern auch einen Spektralanteil bei der Ausgangsgrundfrequenz des erdschlussbehafteten Maschinenbereiches. Daher kann ein Erdschluss in einem Maschinenbereich des IT-Netzes auch dadurch erkannt werden, dass das Frequenzspektrum der Netzspannung des Stromübertragungsnetzes einen Spektralanteil aufweist, der mit der Ausgangsgrundfrequenz der Ausgangsspannung des mit dem Maschinenbereich verbundenen Wechselrichters übereinstimmt.

Weitergestaltungen der vorgenannten Ausgestaltung der Erfindung sehen vor, dass als Ausgangsgrundfrequenz eine Sollgrundfrequenz der Ausgangsspannung des Wechselrichters verwendet wird, oder dass die Ausgangsgrundfrequenz gemessen wird.

Die Messung der Ausgangsgrundfrequenz ermöglicht eine zuverlässige Bestimmung der Ausgangsgrundfrequenz. Demgegenüber hat die Verwendung einer Sollgrundfrequenz der Ausgangsspannung des Wechselrichters als Ausgangsgrundfrequenz den Vorteil, dass die Ausgangsgrundfrequenz nicht gemessen werden muss.

Eine weitere Ausgestaltung der Erfindung sieht vor, dass als Gleichtaktspannungseigenschaft ein Frequenzspektrum einer Netzspannung des Stromübertragungsnetzes gegenüber einem Erdpotential erfasst wird, als Ausgangsspannungseigenschaft eine Schaltfrequenz der Ausgangsspannung des Wechselrichters verwendet wird und auf den Maschinenbereich als Ursache des Erdschlusses geschlossen wird, wenn das Frequenzspektrum der Netzspannung einen mit der Schaltfrequenz der Ausgangsspannung des Wechselrichters übereinstimmenden Spektralanteil aufweist.

Diese Ausgestaltung der Erfindung kann insbesondere mit der zuvor beschriebenen derart kombiniert werden, dass auf einen Maschinenbereich als Ursache des Erdschlusses dann geschlossen wird, wenn das Frequenzspektrum der Netzspannung sowohl einen Spektralanteil bei der Sollgrundfrequenz der Ausgangsspannung als auch einen Spektralanteil bei der Schaltfrequenz des Stromrichters enthält. Diese Auswertung des Frequenzspektrums bietet den Vorteil, dass ein Maschinenbereich auch dann eindeutig als Ursache des Erdschlusses identifiziert werden kann, wenn die Ausgangsspannungen zweier Stromrichter identische Sollgrundfrequenzen, aber unterschiedliche Schaltfrequenzen oder identische Schaltfrequenzen, aber unterschiedliche Sollgrundfrequenzen aufweisen.

Weitere Ausgestaltungen der Erfindung sehen vor, dass eine Steuerungseinheit des Stromrichters die Ansteuerung des Stromrichters sperrt oder eine übergeordnete Netzsteuerungseinheit des IT-Netzes den Stromrichter sperrt, wenn auf den Maschinenbereich als Ursache des Erdschlusses geschlossen wird.

Diese Ausgestaltungen der Erfindung ermöglichen, einen Maschinenbereich durch die Steuerungseinheit des zugehörigen Stromrichters oder durch Sperrung des zugehörigen Stromrichters mittels einer übergeordneten Netzsteuerungseinheit des IT-Netzes abzuschalten, wenn auf den Maschinenbereich als Ursache des Erdschlusses geschlossen wird.

Die oben beschriebenen Eigenschaften, Merkmale und Vorteile dieser Erfindung sowie die Art und Weise, wie diese erreicht werden, werden klarer und deutlicher verständlich im Zusammenhang mit der folgenden Beschreibung von Ausführungsbeispielen, die im Zusammenhang mit einer Zeichnung näher erläutert wird.

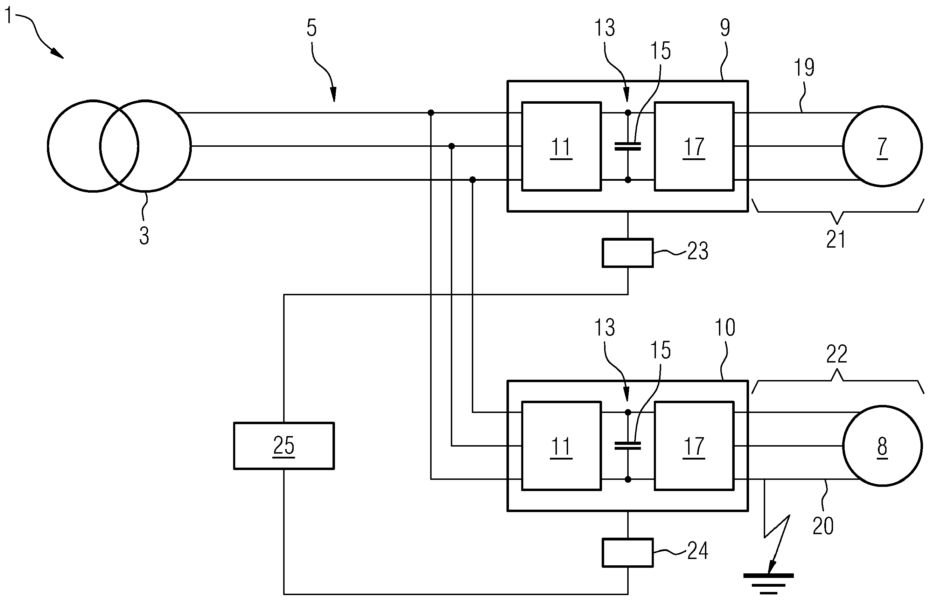

Dabei zeigt die einzige Figur schematisch ein IT-Netz 1 mit einer Stromquelle 3, einem Stromübertragungsnetz 5 und zwei rotierenden elektrischen Maschinen 7, 8, die jeweils über einen Stromrichter 9, 10 an das Stromübertragungsnetz 5 angeschlossen sind.

Das Stromübertragungsnetz 5 des in der Figur dargestellten IT-Netzes 1 ist ein dreiphasiges Wechselstromnetz. Jede elektrische Maschine 7, 8 ist beispielsweise ein dreiphasiger Elektromotor.

Jeder Stromrichter 9, 10 ist eingangsseitig an das Stromübertragungsnetz 5 und ausgangsseitig an eine elektrische Maschine 7, 8 angeschlossen. Ferner ist jeder Stromrichter 9, 10 als ein Umrichter ausgeführt, der einen eingangsseitigen Dreiphasengleichrichter 11, einen Gleichspannungszwischenkreis 13 mit einem Zwischenkreiskondensator 15 und einen ausgangsseitigen Wechselrichter 17 aufweist. Der Dreiphasengleichrichter 11 ist mit dem Stromübertragungsnetz 5 und dem Gleichspannungszwischenkreis 13 verbunden. Der Wechselrichter 17 ist mit dem Gleichspannungszwischenkreis 13 und der jeweiligen elektrischen Maschine 7, 8 verbunden.

Eine erste elektrische Maschine 7 ist über erste Verbindungsleitungen 19 mit einem ersten Stromrichter 9 verbunden. Die erste elektrische Maschine 7 und die ersten Verbindungsleitungen 19 definieren einen ersten Maschinenbereich 21 des IT-Netzes 1.

Die zweite elektrische Maschine 8 ist über zweite Verbindungsleitungen 20 mit dem zweiten Stromrichter 10 verbunden. Die zweite elektrische Maschine 8 und die zweiten Verbindungsleitungen 20 definieren einen zweiten Maschinenbereich 22 des IT-Netzes 1.

Das erfindungsgemäße Verfahren dient dazu, einen Erdschluss in einem Maschinenbereich 21, 22 zu erkennen und zu detektieren, in welchem Maschinenbereich 21, 22 der Erdschluss auftritt, um diesen Maschinenbereich 21, 22 gezielt abzuschalten und so das restliche IT-Netz 1 weiter betreiben zu können. In der Figur ist ein Erdschluss in dem zweiten Maschinenbereich 22 durch ein Blitzsymbol angedeutet.

Ein erstes Ausführungsbeispiel des Verfahrens sieht vor, dass für jeden Stromrichter 9, 10 Spannungsimpulse einer Spannung zwischen einem Zwischenkreispotential des Gleichspannungszwischenkreises 13 und einem Erdpotential erfasst und mit Schalthandlungen einer Phase des Wechselrichters 17 des jeweiligen Stromrichters 9, 10 verglichen werden. Wenn für einen der Stromrichter 9, 10 die erfassten Spannungsimpulse zeitgleich mit den Schalthandlungen erfolgen, wird auf den mit diesem Stromrichter 9, 10 verbundenen Maschinenbereich 21, 22 als Ursache eines Erdschlusses geschlossen.

Dabei wird beispielsweise eine Schwellenzeitdauer vorgegeben und ein Spannungsimpuls wird als zeitgleich mit einer Schalthandlung definiert, wenn ein zeitlicher Abstand zwischen dem Spannungsimpuls und der Schalthandlung kleiner als die Schwellenzeitdauer ist. Beispielsweise wird eine Schwellenzeitdauer vorgegeben, die kleiner als 10 µs ist.

Ferner werden beispielsweise eine Zähldauer, beispielsweise etwa eine Sekunde, und ein Anzahlschwellenwert, beispielsweise etwa 1000, vorgegeben und innerhalb der Zähldauer wird eine Bewertungsanzahl von zeitgleichen Spannungsimpulsen und Schalthandlungen erfasst. Auf einen Maschinenbereich 21, 22 als Ursache eines Erdschlusses wird nur dann geschlossen, wenn für den mit diesem Maschinenbereich 21, 22 verbundenen Stromrichter 9, 10 die Bewertungsanzahl den Anzahlschwellenwert überschreitet.

Die Schalthandlungen einer Phase des Wechselrichters 17 eines Stromrichters 9, 10 werden beispielsweise durch eine Messung der Ausgangsspannung der Phase gegen ein Zwischenkreispotential des Gleichspannungszwischenkreises des Stromrichters 9, 10 erfasst oder aus Ansteuersignalen zur Ansteuerung der Phase ermittelt.

Ein zweites Ausführungsbeispiel des Verfahrens unterscheidet sich von dem ersten Ausführungsbeispiel im Wesentlichen nur dadurch, dass anstelle von Spannungsimpulsen der Spannungen an den Gleichspannungszwischenkreisen 13 der Stromrichter 9, 10 Spannungsimpulse einer Netzspannung des Stromübertragungsnetzes gegenüber einem Erdpotential erfasst und jeweils mit Schalthandlungen einer Phase des Wechselrichters 17 jedes Stromrichters 9, 10 verglichen werden. Wenn für einen der Stromrichter 9, 10 die erfassten Spannungsimpulse zeitgleich mit den Schalthandlungen erfolgen, wird auf den mit diesem Stromrichter 9, 10 verbundenen Maschinenbereich 21, 22 als Ursache eines Erdschlusses geschlossen. Ausgestaltungen dieses Ausführungsbeispiels hinsichtlich der Definition und Erkennung zeitgleicher Spannungsimpulse und Schalthandlungen sowie der Ermittlung der Schalthandlungen einer Phase eines Wechselrichters 17 entsprechen den oben genannten Ausgestaltungen des ersten Ausführungsbeispiels.

Bei einem dritten Ausführungsbeispiel des Verfahrens wird ein Frequenzspektrum einer Netzspannung des Stromübertragungsnetzes gegenüber einem Erdpotential erfasst und mit der Ausgangsgrundfrequenz und/oder der Schaltfrequenz der Ausgangsspannung des Wechselrichters 17 jedes Stromrichters 9, 10 verglichen. Wenn die Ausgangsspannungen der Wechselrichter 17 der Stromrichter 9, 10 unterschiedliche Ausgangsgrundfrequenzen aufweisen, wird auf einen Maschinenbereich 21, 22 als Ursache eines Erdschlusses geschlossen, wenn das erfasste Frequenzspektrum einen Spektralanteil aufweist, der mit der Ausgangsgrundfrequenz der Ausgangsspannung des Wechselrichters 17 desjenigen Stromrichters 9, 10 übereinstimmt, der mit diesem Maschinenbereich 21, 22 verbunden ist. Wenn die Ausgangsspannungen der Wechselrichter 17 der Stromrichter 9, 10 gleiche Ausgangsgrundfrequenzen aber unterschiedliche Schaltfrequenzen aufweisen, wird auf einen Maschinenbereich 21, 22 als Ursache eines Erdschlusses geschlossen, wenn das erfasste Frequenzspektrum einen Spektralanteil aufweist, der mit der Schaltfrequenz der Ausgangsspannung des Wechselrichters 17 desjenigen Stromrichters 9, 10 übereinstimmt, der mit diesem Maschinenbereich 21, 22 verbunden ist.

In dem in der Figur dargestellten Fall eines mehrphasigen Stromübertragungsnetzes 5 wird als Netzspannung beispielsweise eine Phasenspannung oder die Summe aller Phasenspannungen des Stromübertragungsnetzes 5 gegenüber einem Erdpotential verwendet.

Als Ausgangsgrundfrequenz der Ausgangsspannung eines Wechselrichters 17 wird beispielsweise eine Sollgrundfrequenz der Ausgangsspannung des Wechselrichters 17 verwendet oder die Ausgangsgrundfrequenz wird gemessen.

In allen oben genannten Ausführungsbeispielen wird ein Maschinenbereich 21, 22, in dem ein Erdschluss erkannt wird, beispielsweise abgeschaltet, indem eine Steuerungseinheit 23, 24 des mit diesem Maschinenbereich 21, 22 verbundenen Stromrichters 9, 10 die Ansteuerung des Stromrichters 9, 10 sperrt, oder indem eine übergeordnete Netzsteuerungseinheit 25 des IT-Netzes 1 den mit diesem Maschinenbereich 21, 22 verbundenen Stromrichter 9, 10 sperrt.

Alle oben genannten Ausführungsbeispiele des Verfahrens können analog auch für ein IT-Netz 1 angewendet werden, dessen Stromübertragungsnetz 5 ein Gleichstromnetz ist.

Obwohl die Erfindung im Detail durch bevorzugte Ausführungsbeispiele näher illustriert und beschrieben wurde, so ist die Erfindung nicht durch die offenbarten Beispiele eingeschränkt und andere Variationen können vom Fachmann hieraus abgeleitet werden, ohne den Schutzumfang der Erfindung zu verlassen.

## Patentansprüche

1. Verfahren zum Orten eines Erdschlusses in einem IT-Netz (1), das ein Stromübertragungsnetz (5), eine rotierende elektrische Maschine (7, 8) und einen Stromrichter (9, 10) aufweist, wobei der Stromrichter (9, 10) eingangsseitig an das Stromübertragungsnetz (5) und ausgangsseitig an die elektrische Maschine (7, 8) angeschlossen ist und einen Gleichspannungszwischenkreis (13) und einen mit dem Gleichspannungszwischenkreis (13) und der elektrischen Maschine (7, 8) verbundenen Wechselrichter (17) aufweist, wobei
- eine Gleichtaktspannungseigenschaft einer Gleichtaktspannung des Stromrichters (9, 10) oder des Stromübertragungsnetzes (5) erfasst wird,
- die Gleichtaktspannungseigenschaft mit einer Ausgangsspannungseigenschaft einer Ausgangsspannung des Wechselrichters (17) verglichen wird,
- und im Falle eines Erdschlusses in dem IT-Netz (1) anhand des Vergleiches der Gleichtaktspannungseigenschaft mit der Ausgangsspannungseigenschaft darauf geschlossen wird, ob ein dem Stromrichter (9, 10) nachgeschalteter Maschinenbereich (21, 22) des IT-Netzes (1), der die elektrische Maschine (7, 8) und eine Verbindungsleitung (19, 20) zwischen der elektrischen Maschine (7, 8) und dem Stromrichter (9, 10) aufweist, die Ursache des Erdschlusses ist.

2. Verfahren nach Anspruch 1,
**dadurch gekennzeichnet, dass** als Gleichtaktspannungseigenschaft Spannungsimpulse einer Spannung zwischen einem Zwischenkreispotential des Gleichspannungszwischenkreises (13) und einem Erdpotential erfasst werden, als Ausgangsspannungseigenschaft Schalthandlungen einer Phase des Wechselrichters (17) verwendet werden und auf den Maschinenbereich (21, 22) als Ursache des Erdschlusses geschlossen wird, wenn die Spannungsimpulse zeitgleich mit den Schalthandlungen erfolgen.

3. Verfahren nach Anspruch 1,
**dadurch gekennzeichnet, dass** als Gleichtaktspannungseigenschaft Spannungsimpulse einer Netzspannung des Stromübertragungsnetzes (5) gegenüber einem Erdpotential erfasst werden, als Ausgangsspannungseigenschaft Schalthandlungen einer Phase des Wechselrichters (17) verwendet werden und auf den Maschinenbereich (21, 22) als Ursache des Erdschlusses geschlossen wird, wenn die Spannungsimpulse zeitgleich mit den Schalthandlungen erfolgen.

4. Verfahren nach Anspruch 2 oder 3,
**dadurch gekennzeichnet, dass** eine Schwellenzeitdauer vorgegeben wird und ein Spannungsimpuls als zeitgleich mit einer Schalthandlung definiert wird, wenn ein zeitlicher Abstand zwischen dem Spannungsimpuls und der Schalthandlung kleiner als die Schwellenzeitdauer ist.

5. Verfahren nach Anspruch 4,
**dadurch gekennzeichnet, dass** eine Schwellenzeitdauer vorgegeben wird, die kleiner als 10 µs ist.

6. Verfahren nach einem der Ansprüche 2 bis 5,
**dadurch gekennzeichnet, dass** eine Zähldauer und ein Anzahlschwellenwert vorgegeben werden und innerhalb der Zähldauer eine Bewertungsanzahl von zeitgleichen Spannungsimpulsen und Schalthandlungen erfasst wird, und dass auf den Maschinenbereich (21, 22) als Ursache des Erdschlusses geschlossen wird, wenn die Bewertungsanzahl den Anzahlschwellenwert überschreitet.

7. Verfahren nach einem der Ansprüche 2 bis 6,
**dadurch gekennzeichnet, dass** die Schalthandlungen einer Phase des Wechselrichters (17) durch eine Messung der Ausgangsspannung der Phase gegen ein Zwischenkreispotential des Gleichspannungszwischenkreises (13) erfasst werden.

8. Verfahren nach einem der Ansprüche 2 bis 6,
**dadurch gekennzeichnet, dass** die Schalthandlungen einer Phase des Wechselrichters (17) aus Ansteuersignalen zur Ansteuerung der Phase ermittelt werden.

9. Verfahren nach Anspruch 1,
**dadurch gekennzeichnet, dass** als Gleichtaktspannungseigenschaft ein Frequenzspektrum einer Netzspannung des Stromübertragungsnetzes (5) gegenüber einem Erdpotential erfasst wird, als Ausgangsspannungseigenschaft eine Ausgangsgrundfrequenz der Ausgangsspannung des Wechselrichters (17) verwendet wird und auf den Maschinenbereich (21, 22) als Ursache des Erdschlusses geschlossen wird, wenn das Frequenzspektrum der Netzspannung einen mit der Ausgangsgrundfrequenz übereinstimmenden Spektralanteil aufweist.

10. Verfahren nach Anspruch 9,
**dadurch gekennzeichnet, dass** im Falle eines mehrphasigen Stromübertragungsnetzes (5) als Netzspannung eine Phasenspannung oder die Summe aller Phasenspannungen des Stromübertragungsnetzes (5) gegenüber einem Erdpotential verwendet wird.

11. Verfahren nach Anspruch 9 oder 10,
**dadurch gekennzeichnet, dass** als Ausgangsgrundfrequenz eine Sollgrundfrequenz der Ausgangsspannung des Wechselrichters (17) verwendet wird.

12. Verfahren nach Anspruch 9 oder 10,
**dadurch gekennzeichnet, dass** die Ausgangsgrundfrequenz gemessen wird.

13. Verfahren nach Anspruch 1 oder einem der Ansprüche 9 bis 12,
**dadurch gekennzeichnet, dass** als Gleichtaktspannungseigenschaft ein Frequenzspektrum einer Netzspannung des Stromübertragungsnetzes (5) gegenüber einem Erdpotential erfasst wird, als Ausgangsspannungseigenschaft eine Schaltfrequenz der Ausgangsspannung des Wechselrichters (17) verwendet wird und auf den Maschinenbereich (21, 22) als Ursache des Erdschlusses geschlossen wird, wenn das Frequenzspektrum der Netzspannung einen mit der Schaltfrequenz der Ausgangsspannung des Wechselrichters (17) übereinstimmenden Spektralanteil aufweist.

14. Verfahren nach einem der vorhergehenden Ansprüche,
**dadurch gekennzeichnet, dass** eine Steuerungseinheit (23, 24) des Stromrichters (9, 10) die Ansteuerung des Stromrichters (9, 10) sperrt, wenn auf den Maschinenbereich (21, 22) als Ursache des Erdschlusses geschlossen wird.

15. Verfahren nach einem der Ansprüche 1 bis 13,
**dadurch gekennzeichnet, dass** eine übergeordnete Netzsteuerungseinheit (25) des IT-Netzes (1) den Stromrichter (9, 10) sperrt, wenn auf den Maschinenbereich (21, 22) als Ursache des Erdschlusses geschlossen wird.
